# EUROPÄISCHE PATENTSCHRIFT

(11) **EP 2 641 278 B1**
(45) Veröffentlichungstag und Bekanntmachung des Hinweises auf die Patenterteilung: **16.08.2017**
(21) Anmeldenummer: 11781788.2
(22) Anmeldetag: 08.11.2011
(51) Int. Cl.: H01L 33/62, H01L 33/48

(54) **OPTOELEKTRONISCHES HALBLEITERBAUELEMENT**
OPTO-ELECTRONIC SEMICONDUCTOR COMPONENT
COMPOSANT SEMI-CONDUCTEUR OPTOÉLECTRONIQUE

(30) Priorität: 19.11.2010 DE 102010051959
(43) Veröffentlichungstag der Anmeldung: 25.09.2013
(73) Patentinhaber: OSRAM Opto Semiconductors GmbH, 93055 Regensburg (DE)
(72) Erfinder: HÖHN, Klaus, 91301 Forchheim (DE)
(74) Vertreter: Epping - Hermann - Fischer
(86) Internationale Anmeldenummer: PCT/EP2011/069672
(87) Internationale Veröffentlichungsnummer: WO 2012/065882

(56) Entgegenhaltungen:
- WO-A2-2008/042110
- WO-A2-2010/019459
- DE-A1- 10 234 978
- JP-A- 2006 324 297
- JP-A- 2007 231 072
- US-A1- 2008 057 333
- US-A1- 2008 100 772

## Beschreibung

Es wird ein optoelektronisches Halbleiterbauelement sowie eine Signalleuchte mit einem solchen optoelektronischen Halbleiterbauelement angegeben.

Eine zu lösende Aufgabe besteht darin, ein optoelektronisches Halbleiterbauelement anzugeben, das flexibel einsetzbar ist und bei dem Materialschäden während des Betriebs des optoelektronischen Halbleiterbauelements am Bauelement vermieden werden.

In den Druckschriften DE 102 34 978 A1 und US 2008/0057333 A1 und JP 2006-324297 A sind optoelektronische Halbleiterbauelemente mit verschiedenen Arten von Trägern angegeben.

In der Druckschrift JP 2007-231072 A ist eine widerstandsfähige Beschichtung für elektrische Bauteile angegeben.

In der Druckschrift US 2008/0100772 A1 ist eine Beleuchtungsvorrichtung für einen LC-Display angegeben, die eine Lichtleitplatte aufweist.

Gemäß zumindest einer Ausführungsform des optoelektronischen Halbleiterbauelements umfasst dieses zumindest eine Trägerfolie (engl. carrier foil), wobei die Trägerfolie eine erste Oberfläche und eine der ersten Oberfläche gegenüberliegende zweite Oberfläche aufweist. Bei der Trägerfolie kann es sich um einen mechanisch stabilen Träger handeln, auf dessen erster und/oder zweiter Oberfläche Bauteile des Halbleiterbauelements angeordnet und befestigt sein können. Mit anderen Worten kann die Trägerfolie so beschaffen sein, dass sie selbstragend ist und eine stabile Montage- und/oder Trägergrundlage für die Bauteile darstellt. Das kann heißen, dass die Trägerfolie selbst keiner weiterer Befestigungs- und Stabilisierungsmaßnahmen im Halbleiterbauelement bedarf. Die Trägerfolie ist flexibel und auf- und abrollbar. Vorzugsweise weist die Trägerfolie in Bereichen, in denen sie aufgerollt oder verbogen ist weder Bruchstellen noch Unebenheiten oder ähnliches auf.

Die erste Oberfläche und die zweite Oberfläche sind Teil der Außenflächen der Trägerfolie. Dabei kann die zweite Oberfläche einem Kontaktträger - beispielsweise einer Leiterplatte - im montierten Zustand der Trägerfolie zugewandt sein. Zum Beispiel ist die zweite Oberfläche eine Montagefläche, die zur Montage des optoelektronischen Halbleiterbauelements auf einem Kontaktträger dienen kann.

Gemäß zumindest einer Ausführungsform des optoelektronischen Halbleiterbauelements umfasst dieses zumindest eine elektrisch leitende Kontaktschicht, welche auf der ersten Oberfläche angeordnet ist, die erste Oberfläche stellenweise bedeckt und die zumindest ein Metall enthält. Das kann heißen, dass die elektrisch leitende Kontaktschicht unmittelbar auf die erste Oberfläche der Trägerfolie aufgebracht ist und an diesen Stellen mit der ersten Oberfläche in direktem Kontakt steht. Dabei kann die elektrisch leitende Kontaktschicht mit mehreren voneinander getrennten und elektrisch voneinander isolierten Einzelsegmenten gebildet sein. Beispielsweise sind die Einzelsegmente durch die Trägerfolie voneinander elektrisch isoliert.

Gemäß zumindest einer Ausführungsform bedeckt zumindest eine weitere elektrisch leitende Kontaktschicht zumindest stellenweise die zweite Oberfläche der Trägerfolie. In diesem Fall kann in einer seitlichen Schnittdarstellung des Bauelements die Trägerfolie zwischen den beiden Kontaktschichten angeordnet sein. Beispielsweise sind die Materialien der elektrisch leitenden Kontaktschicht und der weiteren elektrisch leitenden Kontaktschicht identisch.

Gemäß zumindest einer Ausführungsform des optoelektronischen Halbleiterbauelements umfasst dieses zumindest ein strahlungsemittierendes, optoelektronisches Halbleiterbauteil, welches auf einer der Trägerfolie abgewandten Außenfläche der elektrisch leitenden Kontaktschicht angeordnet ist. Beispielsweise handelt es sich bei dem strahlungsemittierenden, optoelektronischen Halbleiterbauteil um einen strahlungsemittierenden Halbleiterchip. Beispielsweise handelt es sich bei dem Halbleiterchip um einen Lumineszenzdiodenchip. Bei dem Lumineszenzdiodenchip kann es sich um einen Leuchtdiodenchip oder um einen Laserdiodenchip handeln.

Gemäß zumindest einer Ausführungsform des optoelektronischen Halbleiterbauelements ist das strahlungsemittierende, optoelektronische Halbleiterbauteil elektrisch leitend mit der zumindest einen elektrisch leitenden Kontaktschicht verbunden. Dazu kann das strahlungsemittierende, optoelektronische Halbleiterbauteil beispielsweise direkt auf die der Trägerfolie abgewandten Außenfläche der elektrisch leitenden Kontaktschicht aufgebracht, beispielsweise aufgeklebt, sein. Die elektrisch leitende Kontaktschicht dient zur elektrischen Kontaktierung des strahlungsemittierenden, optoelektronischen Halbleiterbauteils.

Gemäß zumindest einer Ausführungsform des optoelektronischen Halbleiterbauelements ist die Trägerfolie mit zumindest einem Polymer gebildet oder enthält zumindest einen Polymer, wobei zumindest ein Monomer des Polymers mit zumindest einer C-F-Bindung gebildet ist, wobei C für Kohlenstoff und F für Fluor steht. Das heißt, dass zumindest ein Fluoratom von zumindest einem Monomer des Polymers ein chemisches Grundelement und nicht nur ein optionales, substituierbares chemisches Zusatzelement des Monomers ist. Beispielsweise ist Fluor zur Ausbildung eines Polymers in jedem Monomer des Polymers enthalten. Für den Fall, dass das Polymer ein Copolymer ist, können auch nur ein oder mehrere Monomere einer Monomerart des Polymers mit zumindest einer C-F-Bindung gebildet sein. Mit anderen Worten, dient das Fluor zur Ausbildung von Polymerisationsketten, welche das Material der Trägerfolie bilden.

Gemäß zumindest einer Ausführungsform umfasst das optoelektronische Halbleiterbauelement eine Trägerfolie, die eine erste Oberfläche und eine der ersten Oberfläche gegenüberliegende zweite Oberfläche aufweist. Weiter umfasst das optoelektronische Halbleiterbauelement zumindest eine elektrisch leitende Kontaktschicht, welche auf der ersten Oberfläche angeordnet ist, die erste Oberfläche stellenweise bedeckt und die zumindest ein Metall enthält. Zudem umfasst das optoelektronische Halbleiterbauelement zumindest ein strahlungsemittierendes, optoelektronisches Halbleiterbauteil, welches auf einer der Trägerfolie abgewandten Außenfläche der elektrisch leitenden Kontaktschicht angeordnet ist, wobei das strahlungsemittierende, optoelektronische Halbleiterbauteil elektrisch leitend mit der zumindest einen elektrisch leitenden Kontaktschicht verbunden ist. Die Trägerfolie ist mit zumindest einem Polymer gebildet oder enthält zumindest einen Polymer, wobei jeweils ein Monomer des Polymers mit zumindest einer C-F-Bindung gebildet ist, und C für Kohlenstoff und F für Fluor steht.

Das hier beschriebene optoelektronische Halbleiterbauelement beruht dabei unter anderem auf der Erkenntnis, dass Trägerelemente eines optoelektronischen Halbleiterbauelements, auf dem ein strahlungsemittierendes, optoelektronisches Halbleiterbauteil angeordnet ist, durch die von dem strahlungsemittierenden, optoelektronischen Halbleiterbauteil emittierte elektromagnetische Strahlung geschädigt werden können. Ist ein derartiges Trägerelement beispielsweise mit einem Epoxid gebildet, kann die auf das Trägerelement auftreffende elektromagnetische Strahlung, beispielsweise in einem Wellenlängenbereich von Wellenlängen kleiner als 460 nm zu korrosiven Abbauprodukten in oder am Trägerelement führen, die beispielsweise während des Betriebs des optoelektronischen Halbleiterbauelements zu Schäden am Träger, an Lötstellen des strahlungsemittierenden, optoelektronischen Halbleiterbauteils und am Halbleiterbauteil selbst führen können. Zusätzlich weisen derartige Trägerelemente nur eine geringe Temperatur-Strahlungs- und Witterungsbeständigkeit auf. Beispielsweise kann bereits nach kurzer Betriebsdauer für einen externen Betrachter sowohl das Trägerelement, als auch das strahlungsemittierende, optoelektronische Halbleiterbauteil vergilbt und/oder bräunlich gefärbt erscheinen.

Zwar können beispielsweise durch keramische Trägermaterialien für ein derartiges Trägerelement derartige korrosive Abbauprodukte vermieden werden, allerdings zeigen keramische Trägermaterialien nur eingeschränkte flexible Eigenschaften und sind zudem wenig kostengünstig.

Um nun ein optoelektronisches Halbleiterbauelement anzugeben, bei dem derartige störende korrosive Abbauprodukte vermieden werden, welches eine hohe Temperatur- Strahlungs- und Witterungsbeständigkeit aufweist, und dabei gleichzeitig sowohl flexibel einsetzbar als auch kostengünstig in seiner Herstellung ist, macht das hier beschriebene optoelektronische Halbleiterbauelement unter anderem von der Idee Gebrauch, eine Trägerfolie bereitzustellen, welche mit zumindest einem Polymer gebildet ist oder zumindest einen Polymer enthält, wobei zumindest ein Monomer des Polymers mit zumindest einer C-F-Bindung gebildet ist, wobei C für Kohlenstoff und F für Fluor steht. Vorteilhaft zeigen derartige, mit Fluor gebildete Polymere als Material für die Trägerfolie weder Vergilbungen noch störende Braunfärbungen bei Einstrahlung von elektromagnetischer Strahlung auf sie. Das heißt, dass bei mit derartigen Materialien gebildeten Trägerfolien die störenden korrosiven Abbauprodukte vermieden werden. Zudem zeigen diese Materialien für die Trägerfolie flexible mechanische Eigenschaften. Beispielsweise kann die Trägerfolie je nach Bedarf und Anwendung des optoelektronischen Halbleiterbauelements aufgerollt oder vorgebbar verbogen werden. Weiter zeigen derartige Materialien geringe Ausgasungsraten bei Einstrahlung von elektromagnetischer Strahlung. Zudem kann durch die hier beschriebene Trägerfolie eine möglichst kostengünstige Herstellung durch eine Band-zu-Band (auch Reel-to-Reel) oder Steifenmontage des Halbleiterbauteils auf der elektrisch leitenden Kontaktschicht realisiert werden. Gleichzeitig werden schnelle Schaltzyklen für einen Pulsbetrieb des Halbleiterbauteils ermöglicht.

Gemäß zumindest einer Ausführungsform des optoelektronischen Halbleiterbauelements erzeugt das strahlungsemittierende, optoelektronische Halbleiterbauteil im Betrieb elektromagnetische Strahlung, die auf die erste Oberfläche der Trägerfolie trifft, wobei die erste Oberfläche mit dem Polymer gebildet ist. Die Trägerfolie weist eine vertikale Ausdehnung auf. Die Außenflächen der Trägerfolie sind insbesondere durch die erste Oberfläche und die zweite Oberfläche gebildet, wobei im Betrieb überwiegend auf die erste Oberfläche der Trägerfolie elektromagnetische Strahlung trifft. Das Bulk der Trägerfolie, die erste und zweite Oberfläche bilden dabei Außenflächen aus und sind zumindest durch das gleiche Polymer gebildet oder enthalten zumindest das gleiche Polymer. Mit anderen Worten sind die Außenflächen der Trägerfolie nicht durch ein weiteres insbesondere strahlungsresistentes Material, beispielsweise eine Metallfolie, geschützt. Das heißt, dass die Trägerfolie auch an seinen Außenflächen das Polymer umfasst, welches für sich alleine genommen besonders strahlungsresistent, insbesondere für blaues Licht und/oder UV-Strahlung, ist.

Gemäß zumindest einer Ausführungsform des optoelektronischen Halbleiterbauelements ist die Trägerfolie reflektierend ausgebildet und erscheint insbesondere weiß. Die Trägerfolie umfasst beispielsweise neben dem Polymer Partikel, die unter anderem reflektierend auf die elektromagnetische Strahlung wirken kann. Die Partikel durchsetzen dabei zumindest stellenweise das Polymer und sind insbesondere homogen in der Trägerfolie verteilt. Unter "homogen" versteht man in dem vorliegenden Zusammenhang, dass es innerhalb der Trägerfolie zu keinen lokalen Anhäufungen der Partikel kommt. Mit anderen Worten sind die Partikel gleichmäßig durch die Trägerfolie verteilt. Die Partikel bestehen zum Beispiel zumindest aus einem der folgenden Materialien TiO₂, BaSO₄, ZnO, AlₓO_{y}, ZrO₂ oder enthalten eines der genannten Materialien. Wobei ZrO₂ für blaues Licht besonders geringe Absorptionseigenschaften, also sehr gute Reflexionseigenschaften, aufweist. Des Weiteren erscheint die Trägerfolie insbesondere weiß. Insbesondere erscheint die Trägerfolie über die gesamte Lebensdauer des optoelektronischen Halbleiterbauelements weiß, da sie besonders Temperatur- Strahlungs- und Witterungsbeständig ist und im Betrieb nicht ihre Farbe ändert. Insbesondere ist die Trägerfolie resistent gegenüber elektromagnetischer Strahlung im Wellenlängenbereich kleiner 460nm. Mit anderen Worten vergilbt die Trägerfolie im Betrieb nicht und/oder nimmt eine bräunliche Verfärbung an, selbst wenn die elektromagnetische Strahlung unmittelbar auf die Trägerfolie trifft.

Gemäß zumindest einer Ausführungsform des optoelektronischen Halbleiterbauelements ist das Polymer mit zumindest einem der Materialien Polytetrafluorethylen, Perfluorpropylen, Perfluoralkylvinylether, Polytrifluorchlorethylen, Polyvinylidenfluorid gebildet oder enthält zumindest eines der genannten Materialien. Es hat sich gezeigt, dass die genannten Materialien besonders korrosionsstabil bei Einstrahlung von elektromagnetischer Strahlung sind und zudem die gewünschten flexiblen Materialeigenschaften aufweisen.

Gemäß zumindest einer Ausführungsform weist die Trägerfolie eine Schichtdicke von höchstens 500 µm, bevorzugt von höchstens 125 µm, auf. Ein derartiger Dickenbereich stellt sicher, dass die flexiblen, mechanischen Eigenschaften der Trägerfolie erhalten bleiben und das optoelektronische Halbleiterbauelement eine geringe Ausdehnung in vertikaler Richtung, das heißt senkrecht zu einer Haupterstreckungsrichtung des optoelektronischen Halbleiterbauelements, aufweist. Ein derartiges optoelektronisches Halbleiterbauelement ist daher besonders flach und platzsparend ausgebildet.

Gemäß zumindest einer Ausführungsform ist die elektrisch leitende Kontaktschicht mit zumindest einem der Materialien Cu, Ag, Au, Ni, Pt, Pd gebildet oder enthält zumindest eines der genannten Materialien.

Gemäß zumindest einer Ausführungsform umfasst das optoelektronische Halbleiterbauelement zumindest zwei in vertikaler Richtung übereinander angeordnete Trägerfolien, wobei in der vertikalen Richtung zumindest eine Kontaktschicht oder zumindest eine weitere Kontaktschicht zwischen den Trägerfolien angeordnet ist. Beispielsweise lösen sich in vertikaler Richtung eine Trägerfolie und eine Kontaktschicht oder eine weitere Kontaktschicht gegenseitig ab. In diesem Fall sind die Trägerfolien und die Kontaktschichten übereinander, beispielsweise stapelförmig, angeordnet.

Gemäß zumindest einer Ausführungsform sind auf der der Trägerfolie abgewandten Außenfläche der Kontaktschicht und einer der Trägerfolie abgewandten Außenfläche der weiteren Kontaktschicht jeweils eine Mehrzahl von optoelektronischen Halbleiterbauteilen angeordnet, wobei die Halbleiterbauteile in vertikaler Richtung zumindest stellenweise miteinander überlappen. Beispielweise überlappen auf der Außenfläche der Kontaktschicht angeordnete Halbleiterbauteile mit den ihnen zugeordneten Halbleiterbauteilen, welche auf der Außenfläche der weiteren Kontaktschicht, also gegenüber, angeordnet sind vollständig. In diesem Fall können jeweils zwei Halbleiterbauelemente in Bezug auf die laterale Richtung, als Hauptachse, eine symmetrische Bauelementgruppe ausbilden. Vorteilhaft kann ein derartiges optoelektronisches Halbleiterbauelement besonders flexibel eingesetzt werden, da für einen externen Betrachter das Halbleiterbauelement sowohl in Blickrichtung hin zur ersten Oberfläche als auch in Blickrichtung hin zur zweiten Oberfläche möglichst aneinander angeglichene Beleuchtungseigenschaften aufweist.

Gemäß zumindest einer Ausführungsform beträgt eine Dicke der elektrisch leitenden Kontaktschicht höchstens eine Dicke der Trägerfolie. Eine derartige Dickenobergrenze der elektrisch leitenden Kontaktschicht stellt sicher, dass das strahlungsemittierende, optoelektronische Halbleiterbauteil zum einen einfach elektrisch kontaktierbar ist und zum anderen das optoelektronische Halbleiterbauelement eine möglichst geringe Ausdehnung in vertikaler Richtung aufweist.

Gemäß zumindest einer Ausführungsform beträgt eine Dielektrizitätskonstante der Trägerfolie, bei einer in einem Frequenzbereich von 50 Hz bis höchstens 1 kHz auf die Trägerfolie auftreffenden elektromagnetischen Strahlung, wenigstens 2,0 und höchstens 2,2 in einem CGS-Einheitenbasissystem. Das heißt, dass eine derartige Trägerfolie aufgrund der niedrigen Dielektrizitätskonstante eine besonders geringe Durchlässigkeit für elektrische Felder und/oder auf die Trägerfolie auftreffende elektromagnetische Strahlung aufweist. Insbesondere kann eine derartige Dielektrizitätskonstante durch die oben beschriebenen Materialien für die Trägerfolie erreicht werden. Dabei kann die kleine Dielektrizitätskonstante sicherstellen, dass möglichst wenig der von dem optoelektronischen, strahlungsemittierenden Halbleiterbauteil emittierten elektromagnetischen Strahlung durch die Trägerfolie hindurch dringt und beispielsweise über die zweite Oberfläche der Trägerfolie, also rückseitig, aus dem optoelektronischen Halbleiterbauelement auskoppelt. Insofern kann mittels einer derartigen Trägerfolie ein möglichst hoher von dem Halbleiterbauteil emittierter Strahlungsanteil für physikalische Anwendungen nutzbar gemacht werden.

Gemäß zumindest einer Ausführungsform weist die Trägerfolie einen dielektrischen Verlustfaktor tan(δ), bei einer auf die Trägerfolie mit einer Frequenz von 1 MHz auftreffenden elektromagnetischen Strahlung, von wenigstens 0,6 x 10⁻⁴ und höchstens 0,8 x 10⁻⁴ auf. Ein derartiger dielektrischer Verlustfaktor stellt sicher, dass möglichst wenig elektromagnetische Strahlung von der Trägerfolie absorbiert wird und auch in diesem Fall beispielsweise für physikalische Anwendungen des optoelektronischen Halbleiterbauelements ein möglichst hoher Anteil von der vom Halbleiterbauteil emittierten elektromagnetischen Strahlung zur Verfügung steht und nutzbar gemacht werden kann. Auch in diesem Fall kann ein derartiger dieelektrischer Verlustfaktor durch die oben beschriebenen Materialien für die Trägerfolie erreicht werden.

Gemäß zumindest einer Ausführungsform bildet die elektrisch leitende Kontaktschicht auf der ersten Oberfläche zumindest eine erste Kontaktstelle und zumindest eine zweite Kontaktstelle aus, wobei das strahlungsemittierende, optoelektronische Halbleiterbauteil über die beiden Kontaktstellen elektrisch leitend verbunden oder kontaktierbar ist. Sind beispielsweise auf der der Trägerfolie abgewandten Außenfläche der elektrisch leitenden Kontaktschicht mehrere strahlungsemittierende, optoelektronische Halbleiterbauteile angeordnet, so kann jedem Halbleiterbauteil eine erste und zumindest eine zweite Kontaktsstelle zugeordnet sein. Beispielsweise ist dazu jeweils ein Halbleiterbauteil auf die erste Kontaktstelle aufgebracht, beispielsweise aufgeklebt oder aufgelötet. Die erste Kontaktstelle bildet dabei einen ersten elektrischen Kontakt für das Halbleiterbauteil aus. Die zweite Kontaktstelle kann einen zweiten elektrischen Kontakt für das Halbleiterbauteil ausbilden, wobei die zweite Kontaktstelle beispielsweise mittels einer Bonddrahtkontaktierung mit dem Halbleiterbauteil elektrisch kontaktiert ist.

Gemäß zumindest einer Ausführungsform des optoelektronischen Halbleiterbauelements weist dieses zumindest zwei Anschlussstellen auf, welche auf der zweiten Oberfläche der Trägerfolie angeordnet und elektrisch leitend mit den Kontaktsstellen verbunden sind. Mit anderen Worten sind die Anschlussstellen und die Kontaktstellen auf jeweils gegenüberliegenden Seiten der Trägerfolie an der Trägerfolie angeordnet. Beispielsweise ist jeder Kontaktstelle zumindest eine Anschlussstelle zugeordnet. Beispielsweise findet eine externe elektrische Kontaktierung des strahlungsemittierenden, optoelektronischen Halbleiterbauteils über eine elektrische Kontaktierung der Anschlussstellen statt.

Gemäß zumindest einer Ausführungsform ist jede Kontaktstelle mit der ihr zugeordneten Anschlussstelle direkt elektrisch leitend verbunden. Das heißt, die Kontaktstelle bildet mit der ihr zugeordneten Anschlussstelle eine Einheit und ist mit dieser zusammenhängend ausgebildet. "Direkt" heißt in diesem Zusammenhang, dass eine elektrisch leitende Verbindung zwischen einer Anschlussstelle und einer der Anschlussstelle zugeordneten Kontaktstelle ohne beispielsweise eine zwischen der Anschlussstelle und der Kontaktstelle angeordnete Leiterbahn hergestellt ist. Zum Beispiel sind dazu die Anschlussstelle und die Kontaktstelle in einem einzigen Verfahrensschritt auf die Außenflächen der Trägerfolie aufgebracht. Beispielsweise sind die Anschlussstellen und die Kontaktstelle mit dem gleichen Material gebildet.

Es wird darüber hinaus eine Signalleuchte angegeben.

Gemäß zumindest einer Ausführungsform umfasst die Signalleuchte zumindest ein optoelektronisches Halbleiterbauelement, wie es in einer oder mehreren der hier beschriebenen Ausführungsformen beschrieben ist. Das heißt, die für das hier beschriebene optoelektronische Halbleiterbauelement aufgeführten Merkmale sind auch für die hier beschriebene Signalleuchte offenbart und umgekehrt.

Gemäß zumindest einer Ausführungsform umfasst die Signalleuchte zumindest eine Projektionsfläche, auf welche die aus dem optoelektronischen Halbleiterbauelement ausgekoppelte elektromagnetische Strahlung trifft. Zum Beispiel handelt es sich bei der Projektionsfläche um einen zumindest teilweise strahlungsdurchlässigen Schirm. Beispielsweise ist dieser Schirm in eine Reflexions- und/oder Strahlungsauskoppeleinrichtung der Signalleuchte integriert. Aus dem optoelektronischen Halbleiterbauelement ausgekoppeltes Licht kann auf die Projektionsfläche treffen und von dieser zumindest teilweise aus der Signalleuchte ausgekoppelt werden.

Zum Beispiel ist die Signalleuchte ein Kfz-Scheinwerfer oder ist in einem Kfz-Scheinwerfer verbaut.

Ebenso kann die Signalleuchte ein Kfz-Rücklicht sein oder in einem Kfz-Rücklicht verbaut sein.

Weiter kann die Signalleuchte ein Leselicht sein oder in einem Leselicht verbaut sein.

Im Folgenden wird das hier beschriebene optoelektronische Halbleiterbauelement anhand von Ausführungsbeispielen und den dazugehörigen Figuren näher erläutert.
- Die Figuren 1A, 1B, 2A und 2B: zeigen in schematischen Ansichten Ausführungsbeispiele eines hier beschriebenen optoelektronischen Halbleiterbauelements.
- Die Figuren 3A und 3B: zeigen in schematischen Ansichten ein Ausführungsbeispiel einer hier beschriebenen Signalleuchte.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

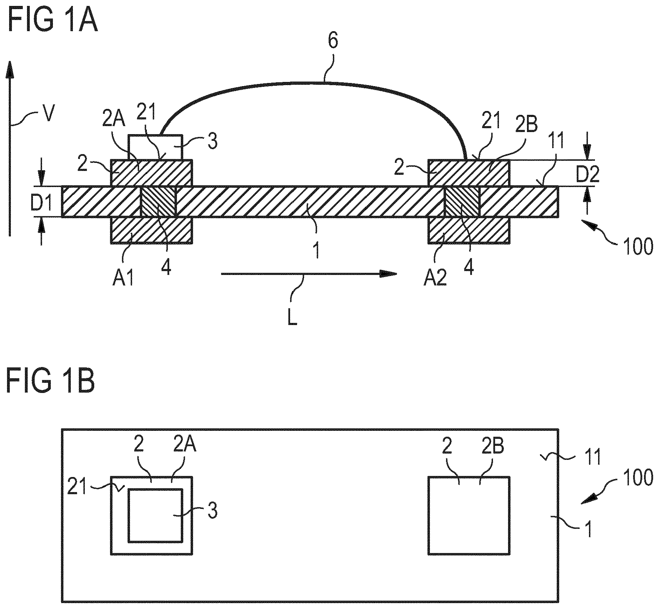

In der Figur 1A ist in einer schematischen Seitenansicht ein hier beschriebenes nicht erfindungsgemäßes optoelektronisches Halbleiterbauelement 100 mit einer Trägerfolie 1 dargestellt. Die Trägerfolie 1 weist eine erste Oberfläche 11 und eine der ersten Oberfläche 11 gegenüberliegende zweite Oberfläche 12 auf. Dabei ist die Trägerfolie 1 mit zumindest einem Polymer gebildet oder enthält zumindest einen Polymer. Vorliegend ist jeweils ein Monomer des Polymers mit zumindest einer C-F-Bindung gebildet, wobei C für Kohlenstoff und F für Fluor steht. Insbesondere kann es sich bei dem Polymer um ein Material handeln, welches mit zumindest einem der Materialien Polytetrafluorethylen, Perfluorpropylen, Perfluoralkylvinylether, Polytrifluorchlorethylen, Polyvinylidenfluorid gebildet ist oder zumindest eines der genannten Materialien enthalten. Die Trägerfolie 1 weist eine Schichtdicke D1 von höchstens 500 µm, bevorzugt von höchstens 125 µm, auf. Eine Dielektrizitätskonstante ε der Trägerfolie 1 beträgt, bei einer in einem Frequenzbereich von wenigstens 50 Hz bis höchstens 1 kHz auf die Trägerfolie 1 auftreffenden elektromagnetischen Strahlung, wenigstens 2,0 und höchstens 2,2 in einem CGS-Einheitenbasissystem. Dabei ist ein dielektrischer Verlustfaktor tan (δ) bei einer auf die Trägerfolie 1 mit einer Frequenz von 1 MHz auftreffenden elektromagnetischen Strahlung, wenigstens 0,6 x 10⁻⁴ und höchstens 0,8 x 10⁻⁴.

Ferner ist auf der ersten Oberfläche 11 eine elektrisch leitende Kontaktschicht 2 angeordnet, welche die erste Oberfläche 11 stellenweise bedeckt und mit zumindest einer der Materialien Cu, Ag, Au, Ni, Pt, Pd gebildet ist oder zumindest eines der genannten Materialien enthält. Dabei bildet die elektrisch leitende Kontaktschicht 2 Kontaktstellen 2A und 2B aus, welche einer lateralen Richtung L nebeneinander und beabstandet voneinander auf der ersten Oberfläche 11 der Trägerfolie 1 angeordnet sind. "Laterale Richtung" heißt in diesem Zusammenhang eine Richtung parallel zur Haupterstreckungsrichtung des optoelektronischen Halbleiterbauelements 100. Auf einer der Trägerfolie 1 abgewandten Außenfläche 21 der Kontaktstelle 2A ist ein strahlungsemittierendes, optoelektronisches Halbleiterbauteil 3 angeordnet. Eine Bonddrahtkontaktierung 6 stellt eine elektrisch leitende Verbindung zwischen der zweiten Kontaktstelle 2B und dem Halbleiterbauteil 3 her. Mit anderen Worten ist das Halbleiterbauteil 3 über die beiden Kontaktstellen 2A und 2B elektrisch leitend kontaktiert. In vertikaler Richtung V unterhalb jeder Kontaktstelle 2A und 2B sind in die Trägerfolie 1 Durchkontaktierungen 4 angebracht, die sich ausgehend von der ersten Oberfläche 11 in Richtung der zweiten Oberfläche 12 durchgehend durch die Trägerfolie 1 hindurch erstrecken. Jeder Kontaktstelle 2A und 2B ist zumindest eine Durchkontaktierung 4 zugeordnet. Mit anderen Worten überlappen die Kontaktstellen 2A und 2B in vertikaler Richtung V zumindest stellenweise mit der ihnen zugeordneten Durchkontaktierung 4. In vertikaler Richtung V über den Durchkontaktierungen 4 auf der zweiten Oberfläche 12 der Trägerfolie 1 ist jeweils eine Anschlussstelle A1 und A2 angeordnet. Vorliegend bilden die Anschlussstellen A1, A2 die Durchkontaktierungen 4 und die Kontaktstellen 2A, 2B jeweils eine Kontaktierungsgruppe aus. Mit anderen Worten ist eine elektrisch leitende Verbindung zwischen den Anschlussstellen A1, A2 und den jeweils den Anschlussstellen A1, A2 zugeordneten Kontaktstellen 2A, 2B mittels jeweils zumindest einer Durchkontaktierung 4 hergestellt. Das heißt, dass das optoelektronische, strahlungsemittierende Halbleiterbauteil 3 über die Anschlussstellen A1, A2 von außen extern elektrisch kontaktierbar ist.

Weiter weisen die Kontaktstellen 2A, 2B eine Dicke D2 auf, die höchstens eine Dicke D1 der Trägerfolie 1 beträgt. Dies stellt sicher, dass das optoelektronische Bauelement 100 eine möglichst geringe Ausdehnung in vertikaler Richtung V aufweist. Ein derartiges optoelektronisches Halbleiterbauelement 100 ist daher flach und platzsparend.

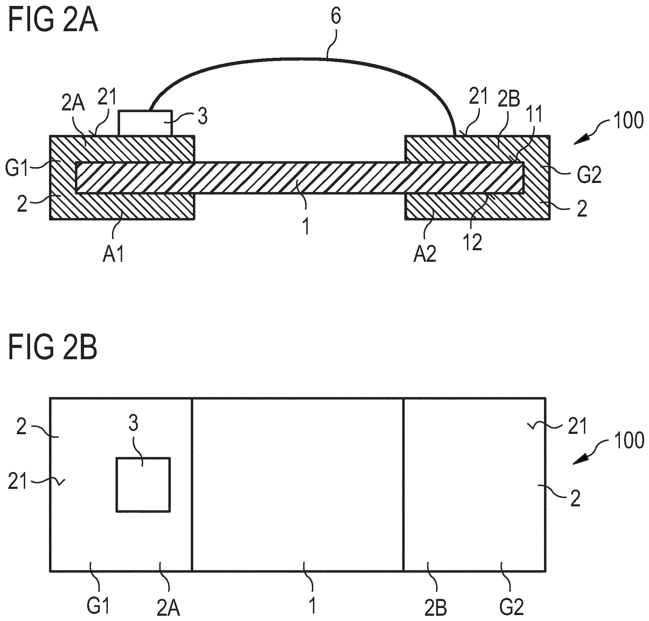

In der Figur 1B ist in einer schematischen Draufsicht das in der Figur 1A gezeigte nicht erfindungsgemäße optoelektronische Bauelement 100 dargestellt. Wiederum erkennbar ist die erste Oberfläche 11 und die auf der ersten Oberfläche 11 angeordneten Kontaktstellen 2A und 2B, wobei vorliegend auf die Darstellung der Bonddrahtkontaktierung 6 verzichtet ist. In der Figur 2A ist einer schematischen Seitenansicht ein weiteres Ausführungsbeispiel eines hier beschriebenen optoelektronischen Halbleiterbauelements 100 gezeigt. Im Unterschied zu dem in den Figuren 1A und 1B gezeigten nicht erfindungsgemäßen Ausführungsbeispiel ist bei dem in der Figur 2A gezeigten erfindungsgemäßen Ausführungsbeispiel auf die Durchkontaktierungen 4 verzichtet. Stattdessen ist jede Kontaktstelle 2A, 2B mit der ihr zugeordneten Anschlussstelle A1, A2 direkt elektrisch leitend verbunden. Das heißt, dass die Kontaktstellen 2A, 2B mit den ihnen zugeordneten Anschlussstellen A1, A2 jeweils durchgehend und zusammenhängend ausgebildet sind. Mit anderen Worten bilden die Kontaktstellen 2A, 2B und die ihnen zugeordneten Anschlussstellen A1, A2 eine Einheit. Dazu sind die Kontaktstellen 2A und 2B jeweils ausgehend von der ersten Oberfläche 11 in Richtung weg voneinander entlang der beiden Oberflächen 11 und 12 der Trägerfolie 1 geführt und münden direkt, das heißt ohne Unterbrechung, in die ihnen jeweils zugeordneten Anschlussstellen A1, A2. Mit anderen Worten umklammern durch die Kontaktstellen 2A und 2B und die Anschlussstellen A1, A2 ausgebildete Kontaktierungsgruppen G1 und G2 die Trägerfolie 1 zumindest stellenweise seitlich.

In der Figur 2B ist in einer schematischen Draufsicht das in der Figur 2A beschriebene erfindungsgemäße Ausführungsbeispiel des optoelektronischen Halbleiterbauelements 100 dargestellt. Dabei sind wiederum die Kontaktierungsgruppen G1 und G2 erkennbar, die die Trägerfolie 1 seitlich umklammern.

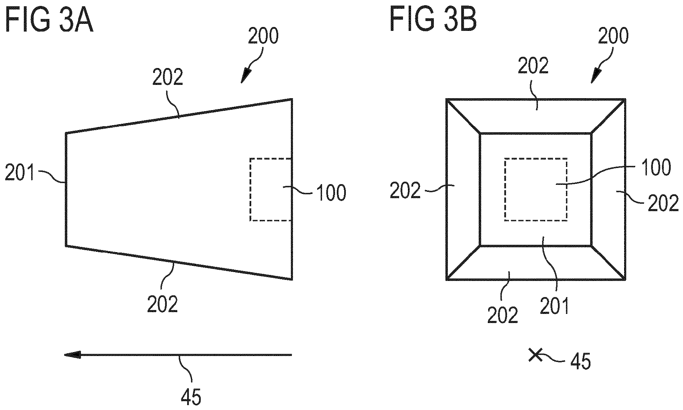

Die Figuren 3A und 3B zeigen in schematischen Seitenansichten eine hier beschriebene Signalleuchte 200. Die Signalleuchte 200 weist das optoelektronisches Halbleiterbauelement 100 auf. Das optoelektronische Halbleiterbauelement 100 emittiert elektromagnetische Strahlung einer vorgebbaren Intensität in Richtung einer Projektionsfläche 201. Zum Beispiel ist die Projektionsfläche 201 mit einem Glas oder mit einem strahlungsdurchlässigen Kunststoff gebildet. Die aus dem optoelektronischen Halbleiterbauelement 100 emittierte elektromagnetische Strahlung wird zumindest teilweise über die Projektionsfläche 201 aus der Signalleuchte 200 ausgekoppelt. Sowohl das optoelektronische Halbleiterbauelement 100 als auch die Projektionsfläche 201 sind in einer Richtung quer zu einer Strahlungsaustrittsrichtung 45 des optoelektronischen Halbleiterbauelements 100 von zumindest einem Reflexionskörper 202 berandet, wobei der Reflexionskörper 202 auf ihn auftreffende elektromagnetische Strahlung zumindest teilweise in Richtung der Projektionsfläche 201 lenkt. Beispielsweise ist der Reflektionskörper 202 ein lichtleitendes Element oder zumindest ein Teil eines solchen. In diesem Fall kann es sich bei dem Reflektionskörper 202 um einen Lichtleiter oder um einen Teil eines Lichtleiters handeln.

In der Figur 3B ist die Signalleuchte 200 in Richtung ausgehend von der Projektionsfläche 201 hin zum optoelektronischen Halbleiterbauelement 100, also entgegen der Strahlungsaustrittsrichtung 45, gezeigt. Gestrichelt dargestellt ist wiederum das optoelektronische Halbleiterbauelement 100, welches von der Projektionsfläche 201 verdeckt ist. Zum Beispiel handelt es sich bei der in den Figuren 3A und 3B beschriebenen Signalleuchte 200 um einen Kfz-Scheinwerfer, eine Leuchte, ein Kfz-Rücklicht oder um ein Leselicht.

Die Erfindung ist nicht durch die Beschreibung anhand der Ausführungsbeispiele beschränkt.

## Patentansprüche

1. Optoelektronisches Halbleiterbauelement (100), mit
- zumindest einer Trägerfolie (1), die eine erste Oberfläche (11) und eine der ersten Oberfläche (11) gegenüberliegende zweite Oberfläche (12) aufweist;
- zumindest einer elektrisch leitenden Kontaktschicht (2), welche auf der ersten Oberfläche (11) angeordnet ist, die erste Oberfläche (11) stellenweise bedeckt und die zumindest ein Metall enthält;
- zumindest einem strahlungsemittierenden, optoelektronischen Halbleiterbauteil (3), welches auf einer der Trägerfolie (1) abgewandten Außenfläche (21) der elektrisch leitenden Kontaktschicht (2) angeordnet ist, wobei
- das strahlungsemittierende, optoelektronische Halbleiterbauteil (3) elektrisch leitend mit der zumindest einen elektrisch leitenden Kontaktschicht (2) verbunden ist,
- die Trägerfolie (1) mit zumindest einem Polymer gebildet ist oder zumindest einen Polymer.enthält,
- jeweils ein Monomer des Polymers mit zumindest einer C-F-Bindung gebildet ist, wobei C für Kohlenstoff und F für Fluor steht,
- die vom strahlungsemittierenden, optoelektronischen Halbleiterbauteil (3) im Betrieb erzeugte elektromagnetische Strahlung auf die erste Oberfläche (11) der Trägerfolie (1) trifft, wobei die erste Oberfläche (11) mit dem Polymer gebildet ist,
- die Trägerfolie (1) selbsttragend ausgebildet ist,
- die elektrisch leitende Kontaktschicht (2) auf der ersten Oberfläche (11) zumindest eine erste Kontaktstelle (2A) und zumindest eine zweite Kontaktstelle (2B) ausbildet,
- das strahlungsemittierende, optoelektronische Halbleiterbauelement (3) über die beiden Kontaktstellen (2A, 2B) elektrisch leitend verbunden ist,
**dadurch gekennzeichnet, dass**
- die Trägerfolie (1) eine Schichtdicke (D1) von höchstens 500 µm aufweist und dabei flexibel und auf- und abrollbar ist,
- zumindest zwei Anschlussstellen (A1, A2) auf der zweiten Oberfläche (12) der Trägerfolie (1) angeordnet sind und elektrisch leitend mit den Kontaktstellen (2A, 2B) verbunden sind,
- die erste Kontaktstelle (2A) mit der ihr zugeordneten Anschlussstelle (A1) einstückig ausgebildet ist und eine erste Kontaktierungsgruppe (G1) bildet,
- die zweite Kontaktstelle (2B) mit der ihr zugeordneten Anschlussstelle (A2) einstückig ausgebildet ist und eine zweite Kontaktierungsgruppe (G2) bildet,
- die Kontaktierungsgruppen (G1, G2) die Trägerfolie (1) zumindest stellenweise an äußeren Randflächen umklammern.

2. Optoelektronisches Halbleiterbauelement (100) nach dem vorhergehenden Anspruch,
bei dem die Trägerfolie (1) reflektierend ausgebildet ist.

3. Optoelektronisches Halbleiterbauelement (100) nach dem vorhergehenden Anspruch,
bei dem die Trägerfolie (1) weiß erscheint.

4. Optoelektronisches Halbleiterbauelement (100) nach einem der vorhergehenden Ansprüche,
bei dem das Polymer mit zumindest einem der folgenden Materialien gebildet ist oder zumindest eines der folgenden Materialien enthält: Polytetrafluorethylen, Perfluorpropylen, Perfluoralkylvinylether, Polytrifluorchlorethylen, Polyvinylidenfluorid.

5. Optoelektronisches Halbleiterbauelement (100) nach einem der vorhergehenden Ansprüche,
bei dem die elektrisch leitende Kontaktschicht (2) mit zumindest einem der folgenden Materialien gebildet ist oder zumindest eines der folgenden Materialien enthält: Cu, Ag, Au, Ni, Pt, Pd.

6. Optoelektronisches Halbleiterbauelement (100) nach einem der vorhergehenden Ansprüche,
bei dem eine Dicke (D2) der elektrisch leitenden Kontaktschicht (2) höchstens eine Dicke (D1) der Trägerfolie (1) beträgt.

7. Optoelektronisches Halbleiterbauelement (100) nach einem der vorhergehenden Ansprüche,
bei dem eine Dielektrizitätskonstante (*ε*) der Trägerfolie (1), bei einer in einem Frequenzbereich von wenigstens 50 Hz bis höchstens 1 kHz auf die Trägerfolie (1) auftreffenden elektromagnetischen Strahlung, wenigstens 2,0 und höchstens 2,2 in einem CGS-Einheitenbasissystem beträgt.

8. Optoelektronisches Halbleiterbauelement (100) nach einem der vorhergehenden Ansprüche,
bei dem die Trägerfolie (1) einen dielektrischen Verlustfaktor (tan(δ)), bei einer auf die Trägerfolie (1) mit einer Frequenz von 1 MHz auftreffenden elektromagnetischen Strahlung, von wenigstens 0,6 x 10-4 und höchstens 0,8 x 10⁻⁴ aufweist.

9. Optoelektronisches Halbleiterbauelement (100) nach einem der Ansprüche 1 bis 8, bei dem jede Kontaktstelle (2A, 2B) mit der ihr zugeordneten Anschlussstelle (A1, A2) direkt elektrisch leitend verbunden ist.

10. Signalleuchte (200), mit
- zumindest einem optoelektronischen Halbleiterbauelement (100) nach einem der vorhergehenden Ansprüche, und
- zumindest einer Projektionsfläche (201), auf welche die aus dem optoelektronischen Halbleiterbauelement (100) ausgekoppelte elektromagnetische Strahlung trifft.

11. Verwendung einer Signalleuchte (200) nach Anspruch 10 als Lichtquelle in einem Kfz-Scheinwerfer, eine Leuchte, einem Kfz-Rücklicht oder einem Leselicht.

## Claims

1. Optoelectronic semiconductor device (100), having
- at least one carrier film (1), which has a first surface (11) and a second surface (12) opposite said first surface (11);
- at least one electrically conductive contact layer (2) which is arranged on the first surface (11), covers the first surface (11) in places and contains at least one metal;
- at least one radiation-emitting, optoelectronic semiconductor component (3) which is arranged on an outer face (21), remote from the carrier film (1), of the electrically conductive contact layer (2),
- the radiation-emitting, optoelectronic semiconductor component (3) being electrically conductively connected to the at least one electrically conductive contact layer (2),
- the carrier film (1) being formed with at least one polymer or containing at least one polymer, one monomer of the polymer in each case being formed with at least one C-F bond, where C denotes carbon and F fluorine,
- the electromagnetic radiation generated by the radiation-emitting, optoelectronic semiconductor component (3) when in operation impinging on the first surface (11) of the carrier film (1), the first surface (11) being formed with the polymer,
- the carrier film (1) being of self-supporting construction,
- the electrically conductive contact layer (2) forming at least one first contact point (2A) and at least one second contact point (2B) on the first surface (11),
- the radiation-emitting, optoelectronic semiconductor device (3) being electrically conductively connected by way of the two contact points (2A, 2B),
**characterized in that**
- the carrier film (1) has a film thickness (D1) of at most 500 µm and in this respect is flexible and may be rolled up and unrolled,
- at least two connection points (A1, A2) are arranged on the second surface (12) of the carrier film (1) and are electrically conductively connected to the contact points (2A, 2B),
- the first contact point (2A) is constructed in one piece with the connection point (A1) associated therewith and forms a first contacting group (G1),
- the second contact point (2B) is constructed in one piece with the connection point (A2) associated therewith and forms a second contacting group (G2),
- the contacting groups (G1, G2) grip around the carrier film (1) at least in places at outer edge faces.

2. Optoelectronic semiconductor device (100) according to the preceding claim,
in which the carrier film (1) is of reflective construction.

3. Optoelectronic semiconductor device (100) according to the preceding claim,
in which the carrier film (1) appears white.

4. Optoelectronic semiconductor device (100) according to one of the preceding claims,
in which the polymer is formed with or contains at least one of the following materials: polytetrafluoroethylene, perfluoropropylene, perfluoroalkyl vinyl ether, polychlorotrifluoroethylene, polyvinylidene fluoride.

5. Optoelectronic semiconductor device (100) according to one of the preceding claims,
in which the electrically conductive contact layer (2) is formed with or contains at least one of the following materials: Cu, AG, Au, Ni, Pt, Pd.

6. Optoelectronic semiconductor device (100) according to one of the preceding claims,
in which a thickness (D2) of the electrically conductive contact layer (2) amounts at most to a thickness (D1) of the carrier film (1).

7. Optoelectronic semiconductor device (100) according to one of the preceding claims,
in which a dielectric constant (*ε*) of the carrier film (1), in the case of electromagnetic radiation impinging on the carrier film (1) at a frequency range of from at least 50 Hz to at most 1 kHz, amounts to at least 2.0 and at most 2.2 in the CGS system of units.

8. Optoelectronic semiconductor device (100) according to one of the preceding claims,
in which the carrier film (1) has a dielectric dissipation factor (tan(δ)), in the case of electromagnetic radiation impinging with a frequency of 1 MHz on the carrier film (1), of at least 0.6×10⁻⁴ and at most 0.8×10⁻⁴.

9. Optoelectronic semiconductor device (100) according to one of claims 1 to 8,
in which each contact point (2A, 2B) is electrically conductively connected directly to the connection point (A1, A2) associated therewith.

10. Signal light (200), having
- at least one optoelectronic semiconductor device (100) according to one of the preceding claims, and
- at least one projection surface (201), on which the electromagnetic radiation coupled out of the optoelectronic semiconductor device (100) impinges.

11. Use of a signal light (200) according to claim 10 as a light source in a motor vehicle headlamp, a luminaire, a motor vehicle rear light or a reading light.

## Revendications

1. Dispositif semi-conducteur optoélectronique (100), avec
- au moins un film support (1) qui présente une première surface (11) et une deuxième surface (12) opposée à la première surface (11) ;
- au moins une couche de contact conductrice d'électricité (2) disposée sur la première surface (11), couvrant par endroits la première surface (11) et contenant au moins un métal ;
- au moins un composant semi-conducteur optoélectronique émettant un rayonnement (3), disposé sur une surface extérieure (21) de la couche de contact conductrice d'électricité (2) écartée du film support (1), dans lequel
- le composant semi-conducteur optoélectronique émettant un rayonnement (3) est relié de façon conductrice d'électricité avec l'au moins une couche de contact conductrice d'électricité (2),
- le film support (1) est constitué par au moins un polymère ou contient au moins un polymère, respectivement un monomère du polymère est constitué par au moins une liaison C-F, C représentant le carbone et F le fluor,
- le rayonnement émis par le composant semi-conducteur optoélectronique émettant un rayonnement (3) en fonctionnement rencontre la première surface (11) du film support (1), la première surface (11) étant constituée par le polymère,
- le film support (1) est exécuté de façon autoporteuse,
- la couche de contact conductrice d'électricité (2) constitue au moins un premier point de contact (2A) et au moins un deuxième point de contact (2B) sur la première surface (11),
- le dispositif semi-conducteur optoélectronique émettant un rayonnement (3) est relié de façon conductrice d'électricité via les deux points de contact (2A, 2B),
**caractérisé en ce que**
- le film support (1) présente une épaisseur de couche (D1) maximale de 500 µm tout en étant flexible, enroulable et déroulable,
- au moins deux points de raccordement (A1, A2) sont disposés sur la deuxième surface (12) du film support (1) et reliés de façon conductrice d'électricité avec les points de contacts (2A, 2B),
- le premier point de contact (2A) est exécuté en une seule pièce avec le point de raccordement qui lui est affecté (A1) et constitue un premier groupe d'établissement de contact (G1),
- le deuxième point de contact (2B) est exécuté en une seule pièce avec le point de raccordement qui lui est affecté (A2) et constitue un deuxième groupe d'établissement de contact (G2),
- les groupes d'établissement de contact (G1, G2) englobent au moins par endroits le film support (1) au niveau des surfaces périphériques extérieures.

2. Dispositif semi-conducteur optoélectronique (100) selon la revendication précédente, dans lequel le film support (1) est exécuté de façon réfléchissante.

3. Dispositif semi-conducteur optoélectronique (100) selon la revendication précédente, dans lequel le film support (1) semble blanc.

4. Dispositif semi-conducteur optoélectronique (100) selon l'une des revendications précédentes, dans lequel le polymère est constitué par au moins un des matériaux suivants ou contient au moins un des matériaux suivants : polytétrafluoréthylène, perfluorpropylène, perfluoralkylvinyléther, polytrifluorchloréthylène, polyvinylidènefluoride.

5. Dispositif semi-conducteur optoélectronique (100) selon l'une des revendications précédentes, dans lequel la couche de contact conductrice d'électricité (2) est constituée par au moins un des matériaux suivants ou contient au moins un des matériaux suivants : Cu, Ag, Au, Ni, Pt, Pd.

6. Dispositif semi-conducteur optoélectronique (100) selon l'une des revendications précédentes, dans lequel une épaisseur (D2) de la couche de contact conductrice d'électricité (2) correspond au maximum à une épaisseur (D1) du film support (1).

7. Dispositif semi-conducteur optoélectronique (100) selon l'une des revendications précédentes, dans lequel une constante diélectrique (e) du film support (1) correspond au minimum à 2,0 et au maximum à 2,2 dans un système CGS, en présence d'un rayonnement électromagnétique situé dans la plaque de fréquences entre minimum 50 Hz et maximum 1 kHz rencontrant le film support (1).

8. Dispositif semi-conducteur optoélectronique (100) selon l'une des revendications précédentes, dans lequel le film support (1) présente un facteur de perte diélectrique (tan(δ)) minimal de 0,6 x 10⁻⁴ et maximal de 0,8 x 10⁻⁴ en présence d'un rayonnement électromagnétique d'une fréquence de 1 MHz rencontrant le film support (1).

9. Dispositif semi-conducteur optoélectronique (100) selon l'une des revendications 1 à 8, dans lequel chaque point de contact (2A, 2B) est directement relié de façon conductrice d'électricité avec le point de raccordement qui lui est affecté (A1, A2).

10. Feu de signalisation (200), avec
- au moins un dispositif semi-conducteur optoélectronique (100) selon l'une des revendications précédentes, et
- au moins une surface de projection (201), que le rayonnement électromagnétique déclenché au départ du dispositif semi-conducteur optoélectronique (100) rencontre.

11. Utilisation d'un feu de signalisation (200) selon la revendication 10 comme source lumineuse dans un projecteur de véhicule automobile, un luminaire, un feu arrière de véhicule automobile ou une lampe de lecture.
